# EUROPEAN PATENT SPECIFICATION

(11) **EP 0 642 171 B1**
(45) Date of publication and mention of the grant of the patent: **06.05.1998**
(21) Application number: 94203107.1
(22) Date of filing: 21.02.1991
(51) Int. Cl.: H01L 29/737, H01L 29/10, H01L 29/735

(54) **Lateral bipolar transistor**
Lateraler Bipolartransistor
Transistor bipolaire latéral

(30) Priority: 22.02.1990 JP 42066/90; 22.02.1990 JP 42067/90; 22.02.1990 JP 42068/90
(43) Date of publication of application: 08.03.1995
(62) Divisional of application: 91301383.5
(73) Proprietor: CANON KABUSHIKI KAISHA, Tokyo (JP)
(72) Inventor: Morishita, Masakazu, c/o Canon Kabushiki Kaisha, Ohta-ku, Tokyo (JP)
(74) Representative: Beresford, Keith Denis Lewis

(56) References cited:
- IEEE TRANSACTIONS ON ELECTRON DEVICES, vol.36, no.10, October 1989 pages 2156 - 2164, XP95528 R.L. THORNTON ET AL.
- 1989 SYMPOSIUM ON VLSI TECHNOLOGY, May 1989 pages 95 - 96 G.L. PATTON ET AL.
- G.L. Patton: 1989 Symposium on VLSI Technology, p.95,96, May 22 (1989)

## Description

The present invention relates to a lateral bipolar transistor.

There is already known a lateral bipolar transistor in which the current flows horizontally, namely along or parallel to the surface of the substrate. Such lateral bipolar transistor is widely used because of the advantage that it can be easily compatible with a vertical bipolar transistor in which the current flows vertically, namely in the direction of depth of the substrate. For example, a lateral bipolar transistor of pnp structure can be loaded on a same substrate with a vertical bipolar transistor of opposite npn structure.

However, the conventional lateral bipolar transistor has been associated with a drawback that the current amplification factor h_{FE} cannot be increased because of the following reasons.

This is due to facts that, because of a low emitter-collector breakdown voltage resulting from symmetrical arrangement of the emitter area and the collector area in such lateral bipolar transistor, the base width is apt to be influenced by the collector voltage resulting eventually in so-called Early effect (spreading of depletion layer), and that, because of wide internal spreading of the current flowing from the emitter into the base, the recombined current in the base area governs the function and the increased base current reduces significantly the current amplification factor h_{FE}.

### SUMMARY OF THE INVENTION

The present invention is intended to provide a semiconductor device of a structure capable of increasing lateral bipolar transistor current amplification factor.

A solution to this problem has been described by R.L. Thornton et al : IEEE Transactions on Electron Devices, 36, No.10 (1989), pages 2156-2164. A heterojunction bipolar transistor with lateral current flow is described therein having features defined by the preamble of claim 1 appended hereto. In the structure described therein the emitter, base and collector regions have a common laminated heterostructure in which an active portion of the base is a layer of GaAs. This layer, which extends across the adjacent emitter and collector regions is sandwiched between wider band gap layers of AlGaAs. In forming the emitter and collector regions, Si is diffused to produce a disordered structure in the GaAs layer regions of the emitter and collector. In this step Al diffuses into the emitter and collector portions of the GaAs layer thus producing a graded composition structure having a graded band gap intermediate that of the remainder of the emitter and collector regions and the base region portion of the GaAs layer.

A lateral bipolar transistor in accordance with the present invention is defined in claim 1 of the claims appended.

In the preferred embodiment of this invention, the emitter region, the collector region and a portion of the base located beneath the underside of the emitter and collector regions, are of Si, whilst another portion of the base located only between the emitter and collector regions is of mixed crystal Si₁₋ₓGeₓ.

It is mentioned that vertical bipolar transistors of Si/Si₁₋ₓGeₓ heterostructure are known. An example is given by G.L. Patton et al: 1989 Symposium on VLSI Technology, May 22 (1989), pages 95-96.

### BRIEF DESCRIPTION OF THE DRAWINGS

Fig. 1 is a schematic cross-sectional view of a lateral bipolar transistor as comparative example;
Fig. 2A is a schematic view showing the potential distribution along a line A-A' in Fig. 1;
Fig. 2B is a schematic view showing the potential distribution along a line B-B' in Fig. 1;
Fig. 3 is a chart showing the mobility, life and diffusion length of positive holes as a function of concentration of n-type impurity;
Fig. 4 is a chart showing the change in the band gap as a function of mixed crystal ratio in Si₁₋ₓGeₓ; and
Fig. 5 is a schematic cross-sectional view of a preferred embodiment of the present invention.

### DETAILED DESCRIPTION OF THE PREFERRED EMBODIMENT

As described below there is provided a lateral bipolar transistor as defined in claim 1.

The interface between the first and second portions of the base region functions as a barrier in the direction of depth of the base region to the minority carriers injected from the emitter region into said base region.

The depth of the second portion of the base region can be made shallower than the depth of the emitter and collector regions to concentrate the emitter current in the vicinity of the surface of the substrate. Such current concentration close to the surface of the substrate allows to make the active area of the device thinner, thereby responding to the requirements of higher level of integration and finer geometry.

Furthermore, the depth of the emitter region may be selected to be shorter than the diffusion length of the minority carriers injected from the base region, thereby effectively reducing a component of the base current, namely the current resulting from recombination of the electrons with the positive holes in the emitter region.

In the following, a preferred embodiment of the present invention will be described and will be compared with a comparative example, making reference to the attached drawings of which:

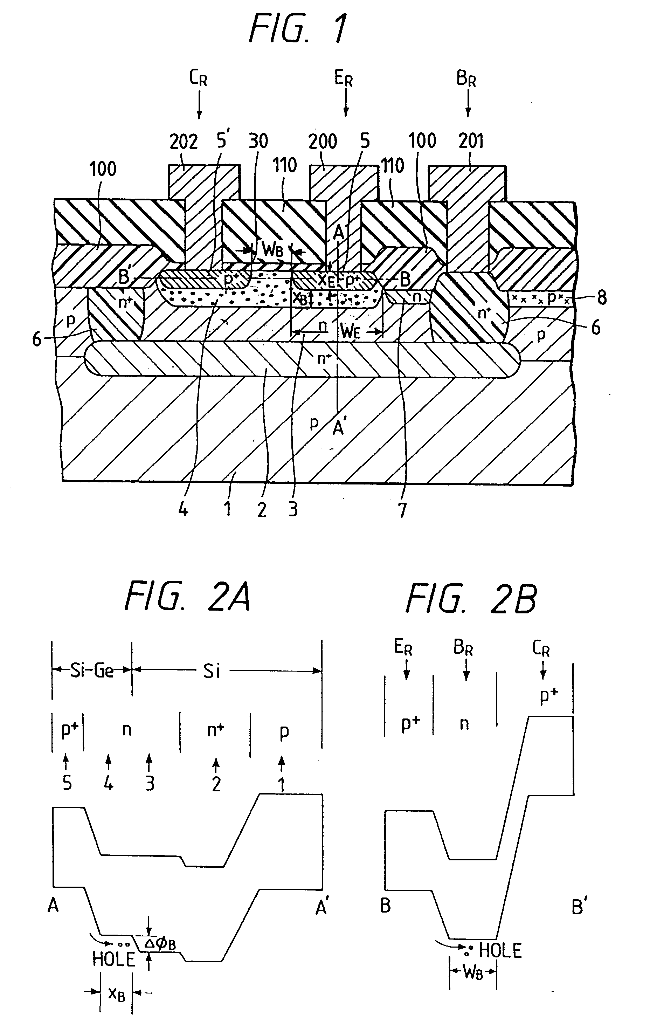

Fig. 1 illustrates a lateral bipolar transistor as a comparative example.

A silicon substrate 1 is composed, in this example of a p-substrate doped with a p-type impurity capable of controlling the conductive type in the p-type, such as boron (B).

An embedded area 2, doped with an impurity capable of controlling the conductive type, is doped in the present embodiment with an n-type impurity such as phosphor (P) with an impurity concentration of 10¹⁶ - 10²⁰ [cm⁻³].

An n-area 3, constituting a part of the base area B_{R}, is for example formed by epitaxial growth with a low impurity concentration (for example 10¹⁴- 5 x 10¹⁷ [cm⁻³]).

An n-area 4 is composed of a mixed crystal Si₁₋ₓGeₓ with a narrower energy band gap than Si, and constitutes the base area B_{R}.

P⁺-areas 5, 5' are formed in said n-area 4 and respectively constitute an emitter area E_{R} and a collector area C_{R}.

An n⁺-area 6 connects said embedded area 2 with a metal base electrode 201, in order to reduce the base resistance of the horizontal bipolar transistor.

An n-area 7 and a p-area 8 constitute channel stops.

There are also shown an oxide film 30, an element separating area 100, an insulating area 110 for separating electrodes, a metal base electrode 201, and a metal collector electrode 202.

Figs. 2A and 2B schematically show the potential distribution of the semiconductor device shown in Fig. 1, respectively along lines A-A' and B-B' shown therein.

As shown in Fig. 2B, the potential distribution along the line B-B' in Fig. 1 is similar to that in the usual bipolar transistor, and the collector current I_{C} can be easily calculated as it is determined by the concentration N_{B} of the base area B_{R} and the base width W_{B}. In the conventional horizontal bipolar transistor, the emitter area and the collector area mutually face only in a very small area, while they are extended quite widely along the surface of the substrate. The collector current flows only through the mutually facing area of the emitter and the collector. On the other hand, the base current is principally governed by a current generated by the recombination of the positive holes, injected from the emitter area E_{R} into the base area B_{R} in the direction of depth of the substrate, with the electrons constituting the majority carriers, and a diffusion current contributed by the electrons injected from the base area into the emitter area, and becomes large because of a wide area involved. These facts pose limitation on the increase of the current amplification factor h_{FE}.

In order to prevent the diffusion of the positive holes, injected from the emitter area, into the direction of depth of the substrate, a heterogeneous interface is formed at a depth χ_{B}, between the n-area 3 and the area 4. The potential distribution in the direction of depth is shown in Fig. 2A.

In the following explained are current components in the horizontal bipolar transistor:

### (I) Collector current I_{C}:

The collector current I_{C} between the mutually opposed emitter and collector can be substantially determined by the following equation.

The magnitude of the emitter area opposed to the collector area in a horizontal bipolar transistor can be approximately represented by χ_{E}·L wherein χ_{E} and L are respectively the depth and length of the emitter.${\text{I}}_{\text{C}} {\text{= χ}}_{\text{E}} \text{·L(} \frac{{\text{q·D}}_{\text{p}} {\text{·n}}_{\text{i}}}{{\text{N}}_{\text{B}} {\text{·L}}_{\text{P}}} {\text{)}}^{\text{2}} \text{cosech(} \frac{{\text{W}}_{\text{B}}}{{\text{L}}_{\text{P}}} \text{) [exp(} \frac{{\text{V}}_{\text{BE}}}{\text{KT}} \text{)-1]}$ wherein q is elementary charge [C], D_{P} is diffusion coefficient [cm²/s] of positive holes, L_{P} is diffusion length [cm] of positive holes, nᵢ is true carrier density [cm⁻³], V_{BE} is emitter-base voltage, W_{B} is base width [cm], N_{B} is base impurity concentration [cm⁻³], χ_{E} is emitter depth, L is emitter length, k is Boltzman constant [J/K],
and T is absolute temperature [°K].

### (II) Base current I_{B} :

The base current I_{B} is principally composed of three components shown in the following equations (2) - (4).
(a) Recombination current I_{B1} generated in the base area B_{R} by the positive holes flowing horizontally from the emitter area E_{R}:${\text{I}}_{\text{B1}} {\text{= χ}}_{\text{E}} \text{·L·(} \frac{{\text{q·D}}_{\text{p}} {\text{· n}}_{\text{i}}^{\text{2}}}{{\text{N}}_{\text{B}} {\text{·L}}_{\text{P}}} \text{) ·} \frac{{\text{cosh (W}}_{\text{B}} {\text{/L}}_{\text{P}} \text{)-1}}{{\text{sinh(W}}_{\text{B}} {\text{/L}}_{\text{P}} \text{)}} \text{· [exp(} \frac{{\text{V}}_{\text{BE}}}{\text{kT}} \text{)-1]}$
(b) Recombination current I_{B2} generated by the positive holes flowing vertically from the emitter area E_{R}:${\text{I}}_{\text{B2}} {\text{= (W}}_{\text{E}} \text{·L)} \frac{{\text{q·n}}_{\text{i}} {}^{\text{2}} {\text{·D}}_{\text{p}}}{{\text{N}}_{\text{B}} {\text{·L}}_{\text{P}}} \text{·tanh (} \frac{{\text{χ}}_{\text{B}}}{{\text{L}}_{\text{P}}} \text{)·[exp(} \frac{{\text{V}}_{\text{BE}}}{\text{kT}} \text{)-1]}$ wherein χ_{B} is the distance in the direction of depth from the emitter area E_{R}, and W_{E} is emitter width.
(c) Diffusion current I_{B3} generated by the electrons flowing from the base area B_{R} to the emitter area E_{R}:${\text{I}}_{\text{B3}} {\text{= (W}}_{\text{E}} \text{·L)} \frac{{\text{q·n}}_{\text{i}} {}^{\text{2}} {\text{·D}}_{\text{n}}}{{\text{N}}_{\text{E}} {\text{·L}}_{\text{n}}} \text{·cotanh(} \frac{{\text{χ}}_{\text{E}}}{{\text{L}}_{\text{n}}} \text{)·[exp(} \frac{{\text{V}}_{\text{BE}}}{\text{kT}} \text{)-1]}$ wherein N_{E} is impurity concentration in the emitter area E_{R}, Lₙ is diffusion length of the electrons,
and Dₙ is diffusion coefficient of the electrons.

In this example, particularly considered is the base current component I_{B2} represented by the equation (3).

In the conventional lateral bipolar transistor, most of the positive holes injected from the emitter area E_{B} flows vertically and contributes to the base current by recombination. On the other hand, in the present example , a potential barrier Δφ_{B} is formed at a distance χ_{B} from the emitter area E_{R} to stop the injected carriers.

The probability of passing through said barrier is represented by exp(-Δφ_{B}/kT).

Said probability, for example at room temperature is Δφ_{B} = 0.1 [eV], which is about 1/54 of that in the conventional lateral bipolar transistor.

If χ_{B} << L_{P} in the equation (3), since tanh(χ_{B}/L_{P}) ≃ χ_{B}/L_{P}, I_{B2} in the lateral bipolar transistor becomes significantly lower than that in the conventional one.

In the following there will be explained the diffusion length L_{P} of positive holes in the n-area.

Following equation stands for the mobility µ_{P} of positive holes, over a wide range of the n-impurity concentration N_{D}:${\text{µ}}_{\text{P}} \text{=} \frac{\text{370}}{{\text{1 + (N}}_{\text{D}} {\text{/8 x 10}}^{\text{17}} {\text{)}}^{\text{1.25}}} {\text{+ 130 [cm}}^{\text{2}} \text{/V·sec]}$ As will be understood from this equation (5), the mobility µ_{P} approaches to a constant value 500 [cm²/V·sec] when the impurity concentration N_{D} becomes smaller, but becomes a function of said concentration N_{D} when it exceeds 10¹⁷ [cm⁻³].

On the other hand, the life τₚ of the minority carriers is represented by the following equation when the impurity concentration exceeds 10¹⁷ [cm⁻³]:$\frac{\text{1}}{{\text{τ}}_{\text{p}}} {\text{= 7.8 x 10}}^{\text{-13}} {\text{N}}_{\text{D}} {\text{+ 1.8 x 10}}^{\text{-31}} {\text{N}}_{\text{D}} {}^{\text{2}} {\text{[sec}}^{\text{-1}} \text{]}$

Based on said mobility µₚ and life τₚ, the diffusion length Lₚ of positive holes is generally represented by:${\text{L}}_{\text{p}} \text{=} \sqrt{\frac{\text{kT}}{\text{q}} {\text{·µ}}_{\text{p}} {\text{·τ}}_{\text{p}}}$

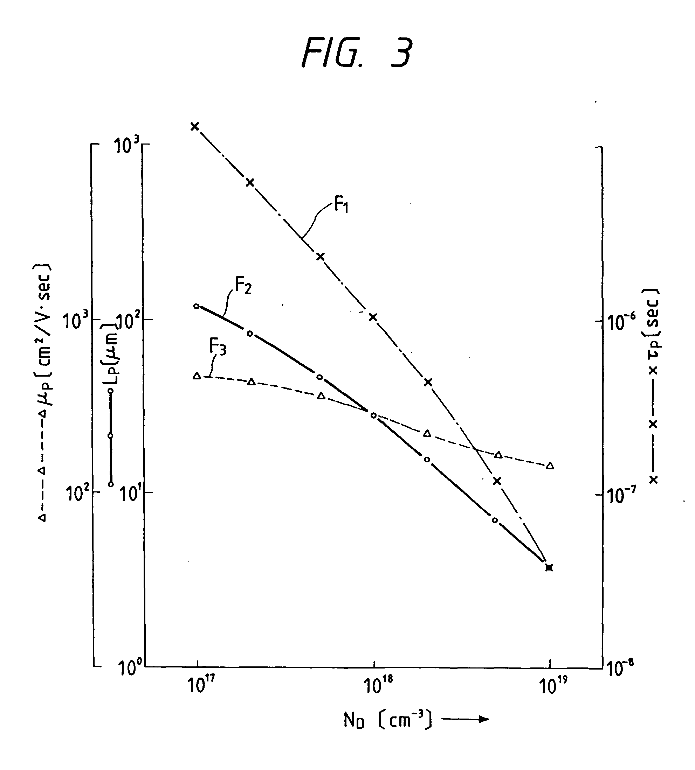

Fig. 3 illustrates the mobility µₚ (curve F₃), life τₚ (curve F₁) and diffusion length Lₚ (curve F₂) of positive holes, constituting the minority carriers in n-type silicon, as calculated from the foregoing equations (5), (6) and (7) in a range of N_{D} of 10¹⁷ - 10¹⁹ [cm⁻³].

As will be apparent from Fig. 3, the diffusion length of positive holes is extremely long and amounts to 120 [µm] at N_{D} = 10¹⁷ [cm⁻³]. It is still about 30 [µm] even at N_{D} = 10¹⁸ [cm⁻³].

In a horizontal bipolar transistor of pnp type formed on a same substrate together with a usual vertical bipolar transistor of npn type, the impurity concentration of the base area becomes same as that of the collector area of said vertical bipolar transistor of npn type and is as low as 10¹⁴ - 5 x 10¹⁷ [cm⁻³], so that the relation χ_{B} << Lₚ can be easily obtained. However a condition of about χ_{B} ≦ Lₚ/10 is desirable.

Under such condition, said recombination current I_{B2} is drastically reduced so that the base current I_{B} is principally governed by I_{B1} and I_{B3} and the current amplification factor h_{FE} can be made close to that of the vertical bipolar transistor. In case of mixed crystal Si₁₋ₓ Geₓ, the mobility of the carriers is reduced due to the alloy effect, but, in a high impurity concentration region (for example 10¹⁸ [cm⁻³] or higher), the impurity effect becomes predominant and the mixed crystal and Si single crystal behave almost same manner.

When said recombination current I_{B2} is decreased, as the components of the base current satisfy a relation I_{B3} << I_{B1}, an increase in the current amplification factor h_{FE} of the horizontal bipolar transistor can be achieved, if W_{E} << Lₚ, by increasing the following ratio:$\frac{{\text{I}}_{\text{C}}}{{\text{I}}_{\text{B3}}} \text{≃} \frac{{\text{χ}}_{\text{E}}}{{\text{W}}_{\text{E}}} \text{·} \frac{{\text{D}}_{\text{p}}}{{\text{D}}_{\text{n}}} \text{·} \frac{{\text{L}}_{\text{n}}}{{\text{L}}_{\text{p}}} \text{·} \frac{{\text{N}}_{\text{E}}}{{\text{N}}_{\text{B}}}$ In designing, χ_{E}/W_{E} and N_{E}/N_{B} can be made easily larger in said equation (8). A larger value of N_{E}/N_{B} is same as in the usual vertical bipolar transistor, but a larger value of χ_{E}/W_{E} is specific to the horizontal bipolar transistor.

In the following there will be explained an example of the manufacturing process of the device of the first embodiment shown in Fig. 1:
(1) On a p-type Si substrate 1, an n⁺-embedded area 2 with an impurity concentration for example of 10¹⁵- 10¹⁹ [cm⁻³] was formed by implantation (or diffusion) of at least an element selected from the elements of group V, such as As, Sb, P etc.
(2) An n-area 3 with an impurity concentration for example of 10¹⁴ - 10¹⁷ [cm⁻³] was formed for example by epitaxial growth.
(3) An n⁺-area 6 (with an impurity concentration for example of 10¹⁷ - 10²⁰ [cm⁻³]) was formed for reducing the base resistance.
(4) An insulating film 100 for element separation was formed by selective oxidation or CVD, and a channel stop area 7 was formed under said insulating film 100.
(5) Ge ions were selectively implanted into the Si substrate 1 for example with an impurity concentration of 1 x 10¹⁶ - 1 x 10¹⁷ [cm⁻²], and a heat treatment was conducted to form an n-area 4 consisting of Si₁₋ₓGeₓ.
(6) B⁺ ions were implanted with a concentration of 1 x 10¹⁵ [cm⁻²], and a heat treatment was conducted to form P⁺-areas 5, 5' constituting the emitter and the collector.
(7) An insulation film 110 was deposited and annealed, and contact holes were opened.
(8) Al-Si (1%) for forming the electrodes 200, 201, 202 was deposited by sputtering and was subsequently patterned.
(9) The alloy formation of said Al-Si electrodes was conducted for example for 30 minutes at 450°C, and a passivation film was formed.

The semiconductor device of the first embodiment was prepared through the above-explained procedure.

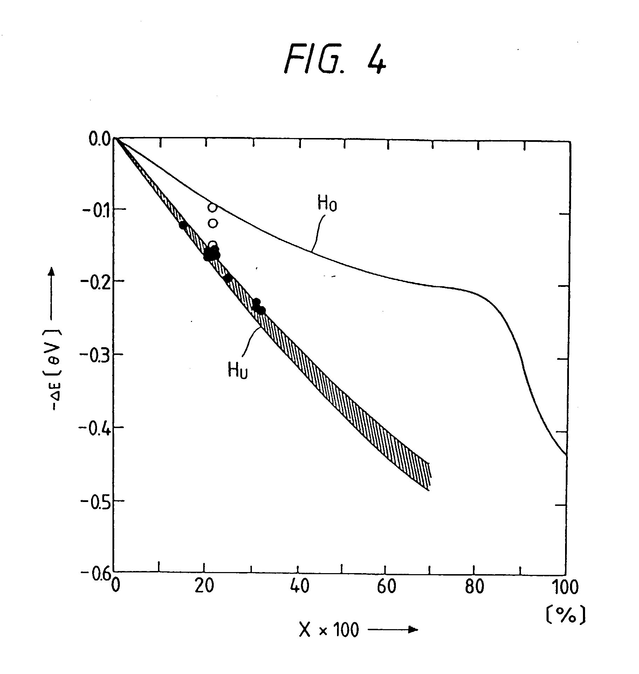

Fig. 4 shows the change in the band gap of the mixed crystal Si₁₋ₓGeₓ, wherein the abscissa indicates the mixed crystal ratio of Ge (X · 100%) whereas the ordinate indicates decrease -ΔE in the band gap in comparison with the Si single crystal. A curve H_{O} indicates a distortion-free state whereas a curve H_{U} indicates a distorted state, which is selected in a semiconductor device.

As shown in Fig. 4, a band gap decrease -ΔE ≃ 0.1 [eV] corresponds approximately to a mixed amount X = 0.12, and a barrier of 0.1 [eV] is formed in this state.

When Ge ions were implanted with a concentration 1 x 10¹⁶ [cm⁻²] and with an accelerating voltage 150 [keV], the peak concentration is about 1 x 10²⁰ [cm⁻³]. Since the density of monocrystalline Si is 5 x 10²³ [cm⁻³], the mixed amount of Ge becomes about 2%. X = 0.12 can be attained for example with a Ge concentration of 6 x 10¹⁶ [cm⁻³].

### [Preferred [Embodiment]

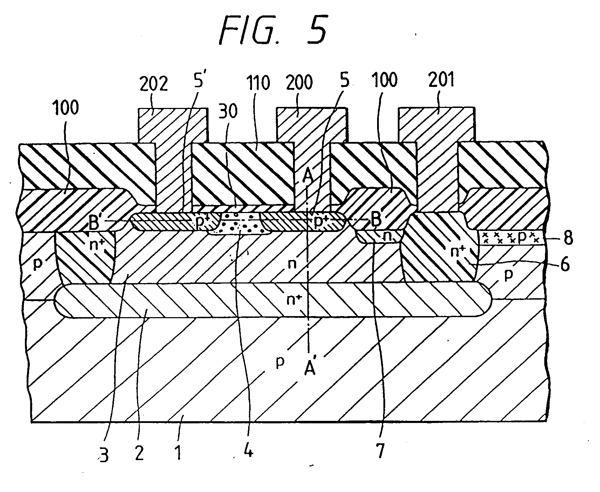

Fig. 5 illustrates a preferred embodiment, wherein the n-area 4 consisting of mixed crystal Si₁₋ₓGeₓ is limited to a smaller area than in the comparative example. Thus the depth of said n-area 4 is comparable to that of the P⁺ emitter and collector areas 5, 5'.

The present invention utilizes a phenomenon that the p-n injection efficiency varies in the p-n junction between the n-area 4 and the p⁺-area 5 because of a smaller band gap in comparison with the p-n junction between the p⁺-area 5 and the n-area 3.

The preferred embodiment is different from the comparative example in that the hole recombination current I_{B2} is given by multiplying the equation (3) with a factor exp(-ΔE/kT), and that the diffusion current I_{B3} is also given by multiplying the equation (4) with a factor exp(-ΔE/kT). An increase in the current amplification factor h_{FE} is attained by these features.

What is essentially important in the present embodiment is the confinement of the collector current in the vicinity of the surface, and, for this reason, the area 4 may be made shallower than the areas 5,5'.

Other structures and functions are the same as those in the foregoing comparative example, and will not, therefore, be explained further.

Also in the foregoing embodiment, the contact of the base area may be composed of Si-Ge mixed crystal, and the contact resistances of the areas can be similarly reduced.

As explained in detail in the foregoing, the present invention can provide a semiconductor device including a lateral bipolar transistor which has a high emitter-collector breakdown voltage, is capable of suppressing so-called Early effect, and has a low base current, thereby capable of increasing the current amplification factor h_{FE}.

Also the present invention can provide a semiconductor device excellent in resistance to ambient conditions.

Furthermore, the semiconductor device of the present invention can be provided inexpensively, since the mass production technology of the conventional integrated circuits can be utilised. Furthermore the semiconductor device of the present invention has a wide field of application, since other elements such as MOS transistors can be simultaneously integrated.

The foregoing embodiment has been limited to a horizontal bipolar transistor of pnp type, but the present invention is naturally applicable to a horizontal bipolar transistor of npn type.

In an operation at room temperature, the value x in Si₁₋ₓGeₓ is preferably at least equal to 0.03, because ΔE needs to be at least to kT. At room temperature, kT ^{∼} 25 meV, so that ΔE functions as a barrier if x is 0.03 or larger. Also in an operation at the temperature of liquid nitrogen, x is preferably at least equal to 0.008. Also the upper limit of the value x is preferably 1.

## Claims

1. A lateral bipolar transistor comprising:
an emitter region (5);
a collector region (5') laterally spaced from and facing said emitter region (5); and
a base region (3,4) which has a first portion (3) located immediately beneath the underside of, and having a respective interface with, said emitter and collector regions (5,5'), and which has a second portion (4) located only in-between said emitter and collector regions (5,5'); wherein
the energy band gap of said second portion (4) of said base region (3,4) is narrower than the energy band gap of said first portion (3) of said base region (3,4);
said lateral bipolar transistor being characterised in that:
the energy band gap of said emitter region (5) and the energy band gap of said collector region (5'), each at said respective interfaces with said first portion (3) of said base region (3,4), and the energy band gap of said first portion (3) of said base region (3,4), are substantially the same; and
the energy band gap of said emitter region (5), and the energy band gap of said collector region (5') each at and over said respective interfaces with said first portion (3) of said base region (3,4), have substantially no variation in the vertical direction of said emitter and collector regions (5,5').

2. A transistor according to claim 1, wherein said first portion (3) of said base region (3,4) is of Si, the material of said emitter and collector regions (5,5') at and over said respective interfaces is of Si, and the region (4) comprising said second portion (4) of said base region (3,4) is of mixed crystal silicon-germanium Si₁₋ₓGeₓ.

3. A transistor according to either preceding claim wherein said second portion (4) of said base region (3,4) has a depth less than that of said emitter and collector regions (5,5').

4. A transistor according to claim 2 wherein said base region (3,4) is in contact with a contact region composed of mixed crystal silicon-germanium.

## Patentansprüche

1. Lateraler Bipolartransistor mit
einem Emitterbereich (**5**),
einem Kollektorbereich (**5'**), der seitlich von dem Emitterbereich (**5**) beabstandet ist und diesem zugewandt ist, und
einem Basisbereich (**3, 4**), der einen ersten Abschnitt (**3**), der unmittelbar unter der Unterseite der Emitter- und Kollektorbereiche (**5, 5'**) angeordnet ist und mit diesen jeweils eine Grenzfläche aufweist, und einen zweiten Abschnitt (**4**) aufweist, der lediglich zwischen dem Emitterbereich (**5**) und dem Kollektorbereich (**5'**) angeordnet ist,
wobei die Energiebandlücke des zweiten Abschnitts (**4**) des Basisbereichs (**3, 4**) schmaler als die Energiebandlücke des ersten Abschnitts (**3**) des Basisbereichs (**3, 4**) ist,
**dadurch gekennzeichnet, daß**
die Energiebandlücke des Emitterbereichs (**5**) und die Energiebandlücke des Kollektorbereichs (**5'**) jeweils an den jeweiligen Grenzflächen mit dem ersten Abschnitt (**3**) des Basisbereichs (**3, 4**) sowie die Energiebandlücke des ersten Abschnitts (**3**) des Basisbereichs (**3, 4**) im wesentlichen gleich sind, und
die Energiebandlücke des Emitterbereichs (**5**) und die Energiebandlücke des Kollektorbereichs (**5'**) jeweils an und über den jeweiligen Grenzflächen mit dem ersten Abschnitt (**3**) des Basisbereichs (**3, 4**) im wesentlichen keine Abweichung in der vertikalen Richtung der Emitter- und Kollektorbereiche (**5, 5'**) aufweisen.

2. Transistor nach Anspruch 1,
**dadurch gekennzeichnet, daß**
der erste Abschnitt (**3**) des Basisbereichs aus Si, das Material der Emitter- und Kollektorbereiche (**5, 5'**) an und über den jeweiligen Grenzflächen aus Si sowie der Bereich (**4**) mit dem zweiten Abschnitt (**4**) des Basisbereichs (**3, 4**) aus einem Si₁₋ₓGeₓ-Silizium-Germanium-Mischkristall besteht.

3. Transistor nach einem der vorangehenden Ansprüche,
**dadurch gekennzeichnet, daß**
der zweite Abschnitt (**4**) des Basisbereichs (**3, 4**) eine Tiefe aufweist, die geringer als die der Emitter- und Kollektorbereiche (**5, 5'**) ist.

4. Transistor nach Anspruch 2,
**dadurch gekennzeichnet, daß**
der Basisbereich (**3, 4**) mit einem aus einem Silizium-Germanium-Mischkristall bestehenden Kontaktbereich in Kontakt steht.

## Revendications

1. Transistor bipolaire latéral comprenant :
une région d'émetteur (5) ;
une région de collecteur (5') espacée latéralement de la région d'émetteur (5) et faisant face à celle-ci; et
une région de base (3, 4) qui a une première partie (3) située immédiatement au-dessous de la face inférieure des régions d'émetteur et de collecteur (5, 5'), et ayant une interface respective avec ces dernières, et qui a une seconde partie (4) située seulement entre les régions d'émetteur et de collecteur (5, 5'); dans lequel
la bande d'énergie interdite de la seconde partie (4) de la région de base (3, 4) est plus étroite que la bande d'énergie interdite de la première partie (3) de la région de base (3, 4);
ce transistor bipolaire latéral étant caractérisé en ce que :
la bande d'énergie interdite de la région d'émetteur (5) et la bande d'énergie interdite de la région de collecteur (5'), chacune d'elles étant considérée aux interfaces respectives avec la première partie (3) de la région de base (3, 4), et la bande d'énergie interdite de la première partie (3) de la région de base (3, 4), sont pratiquement les mêmes; et
la bande d'énergie interdite de la région d'émetteur (5) et la bande d'énergie interdite de la région de collecteur (5'), chacune d'elles étant considérée aux interfaces respectives avec la première partie (3) de la région de base (3, 4), et sur ces interfaces, n'ont pratiquement pas de variation dans la direction verticale des régions d'émetteur et de collecteur (5, 5').

2. Transistor selon la revendication 1, dans lequel la première partie (3) de la région de base (3, 4) consiste en Si, le matériau des régions d'émetteur et de collecteur (5, 5') aux interfaces respectives précitées, et sur ces interfaces, consiste en Si, et la région (4) comprenant la seconde partie (4) de la région de base (3, 4) consiste en silicium-germanium à cristaux mélangés Si₁₋ₓGeₓ.

3. Transistor selon l'une quelconque des revendications précédentes, dans lequel la seconde partie (4) de la région de base (3, 4) a une profondeur inférieure à celle des régions d'émetteur et de collecteur (5, 5').

4. Transistor selon la revendication 2, dans lequel la région de base (3, 4) est en contact avec une région de contact qui consiste en silicium-germanium à cristaux mélangés.
